# EUROPÄISCHE PATENTANMELDUNG

(11) **EP 1 126 503 A1**
(43) Veröffentlichungstag der Anmeldung: **22.08.2001**
(21) Anmeldenummer: 01102931.1
(22) Anmeldetag: 08.02.2001
(51) Int. Cl.: H01J 37/28, G02B 21/00

(54) **Mikroskop mit einem Elektronenstrahl zur Beleuchtung**

(30) Priorität: 19.02.2000 DE 10007650
(71) Anmelder: Leica Microsystems Wetzlar GmbH, 35578 Wetzlar (DE)
(72) Erfinder: Hohn, Fritz Jürgen, Dr., 35745 Herborn (DE)
(74) Vertreter: Reichert, Werner F., Dr.

(57) **Zusammenfassung**

Das Mikroskop (2) ist im wesentlichen dem Aufbau eines herkömmlichen Mikroskops ähnlich. Das Mikroskop (2) besteht aus einem Fußelement (4), auf dem eine Säule (6) aufsitzt. An der Säule (6) ist ein Arm (8) befestigt oder angeformt. In der Nähe des vorderen Endes (10) des Arms (8) befindet sich eine optische Einheit (12), die eine optische Achse (16) festlegt. Eins oder mehrere der am Revolver (20) befestigten Objektive (18) oder (22) sind als sogenannte Objektive für die Rasterelektronenmikroskopie ausgebildet (Elektronenstrahlobjektive). Die Größe der Elektronenstrahlobjektive ist mit der Größe der Objektive für herkömmliche Mikroskope vergleichbar. Durch die Anordnung der Objektive (18) und (22) auf einen Revolver (20), einem Schieber oder einem anderen mechanischen und/oder elektromechanischen Bauteil, kann schnell und einfach zwischen den verschiedenen Vergrößerungen oder Beleuchtungsarten gewechselt werden.

## Beschreibung

Die Erfindung betrifft ein Mikroskop mit einem Elektronenstrahl zur Beleuchtung. Im Besonderen betrifft die Erfindung ein Elektronenmikroskop, das im seinem Aufbau dem eines herkömmlichen Mikroskops ähnlich ist. Die Objektive sind auf einem Revolver angeordnet, so dass das Objektiv mit der gewünschten Vergrößerung in den Strahlengang geschwenkt werden kann.

In dem Artikel mit dem Titel "ELECTRON-BEAM MICROCOLUMN", von T.H.P. Chang et al., erschienen in Microelectronic Engineering 32 (1996), Seiten 113-130, wird die Wichtigkeit der Raster-Elektronen-Mikroskopie bei kleinen Spannungen unterstrichen. Anwendungen ergeben sich in der Oberflächeninspektion, der Metrologie und der Lithographie. Die elektronenoptischen Säulen werden mittels der Mikrostrukturtechnik hergestellt und sind Mehrschichtsysteme aus Schichten mit unterschiedlichen elektrischen Eigenschaften. Die so gefertigten elektronenoptischen Säulen werden bei einer Spannung von ca. 1 keV betrieben.

Die Raster-Elektronen-Mikroskopie ist bekannt und weit entwickelt. Die Auflösung der Raster-Elektronen-Mikroskopie übersteigt die Auflösung optischer Systeme um mehrere Größenordnungen. Eine Auflösung von wenigen Nanometern ist hiermit ohne weiteres möglich. Die US-Patentschrift US-A-5,828,064 offenbart ein Elektronen-Mikroskop, mit dem Proben in einer speziell dafür vorgesehenen Kammer untersucht werden. Der Gasdruck in der Kammer wird zwischen 10⁻² und 50 Torr gehalten. Der Aufbau des Elektronen-Mikroskops besteht aus mindestens vier unterschiedlichen Vakuumzonen, die zwischen der Elektronenkanone und der Probenkammer eine Druckdifferenz von 10⁻¹⁰ Torr herstellen. In der elektronen-optischen Säule, welche auf der Probenkammer aufgesetzt ist, werden die unterschiedlichen Druckbereiche erzeugt. Ein schneller und komfortabler Vergrößerungswechsel ist mit diesem System nicht möglich. Ferner ist der Aufbau eines solchen Raster-Elektronenmikroskops groß, teuer und schwer zu handhaben.

Aufgabe der gegenwärtigen Erfindung ist es, ein Mikroskop zu schaffen, das die Auflösung herkömmlicher Raster-Elektronenmikroskope erreicht und einen kostengünstigen Aufbau besitzt. Das Mikroskop sollte sich kaum von der Baugröße herkömmlicher Lichtmikroskope unterscheiden.

Diese Aufgabe wird gelöst durch ein Mikroskop, dadurch gekennzeichnet, dass mindestens ein in der optischen Achse anordenbares Objektiv als ein Elektronenstrahlobjektiv ausgebildet ist.

Ein Vorteil der Erfindung ist, dass die Proben, bei einer bestimmten Ausführungsform, unter normalen Umgebungsbedingungen untersucht werden können. Die verwendeten Elektronenstrahlobjektive sind in ihrer Größe mit den Objektiven herkömmlicher Lichtmikroskope vergleichbar. Diese Miniaturisierung ist durch die Fortschritte in der Mikrostrukturtechnologie, und hier im Besonderen durch die Technologien bei der Bearbeitung von Silizium, möglich. Ein weiterer Vorteil der Erfindung ist, dass die elektrostatische Aufladung der Proben vermieden wird. Dies liegt zum Einen daran, dass der Elektronenstrahl in den Elektronenstrahlobjektiven mittels kleiner Beschleunigungsspannungen (im Bereich 1keV) erzeugt wird. Zum Anderen wird die Umgebungsluft beim Übergang vom Elektronenstrahlobjektiv zur Probe ionisiert, so dass dadurch eine Ableitung der Ladung ermöglicht wird. Der Aufbau eine Mikroskops gemäß der Erfindung kann besonders vielseitig gestaltet werden. So können z.B. die Elektronenstrahlobjektive auf einem Revolver angebracht werden, was einen schnellen Wechsel zwischen verschiedenen Vergrößerungen erlaubt. Ferner kann zusätzlich zu den Elektronenstrahlobjektiven ein optisches Objektiv vorgesehen sein, das in der Arbeitsposition eine rein optische Beobachtung der Probe bei einer geringeren Auflösung ermöglicht. Da das Mikroskop auch für eine rein optische Abbildung verwendet werden kann, ist eine optische Einheit vorgesehen, die eine optische Achse definiert. Mit der optischen Achse fluchtend, kann ein Elektronenstrahlobjektiv angeordnet sein, das z.B. mittels des Revolvers auf die optische Achse, in die sogenannte Arbeitsposition, verbracht werden kann. Das Elektronenstrahlobjektiv, bestehend aus einer elektronenmikroskopischen Säule, ist in der Arbeitsposition symmetrisch um die optische Achse angeordnet. Für manche Anwendungen ist es besonders vorteilhaft, wenn das Elektronenstrahlobjektiv von der Oberfläche einer zu untersuchenden Probe etwas beabstandet ist. Somit können die Proben unter normalen Umgebungsbedingungen untersucht werden, eine aufwendige Präparation oder gar Zerstörung wird dadurch vermieden. Das Elektronenstrahlobjektiv kann somit derart angeordnet sein, dass zwischen der Probe und dem Elektronenstrahlobjektiv normaler Luftdruck vorherrscht. Ein möglicher Aufbau eines Elektronenstrahlobjektivs ist, dass es aus einem ersten Gehäuse besteht, das ein zweites Gehäuse umschließt. Die elektronenmikroskopische Säule ist im zweiten Gehäuse symmetrisch um die optische Achse angeordnet. Ferner sind entsprechende Vakuumeinrichtungen vorgesehen, die im ersten Gehäuse einen geringeren Luftdruck aufrecht erhalten als in der atmosphärischen Umgebung. Im zweiten Gehäuse wird im Vergleich zum ersten Gehäuse ein noch einmal verbessertes Vakuum hergestellt.

In der Zeichnung ist der Erfindungsgegenstand schematisch dargestellt und wird anhand der Figuren nachfolgend beschrieben. Dabei zeigen:
- Fig. 1: eine schematische Ansicht der erfindungsgemäßen Vorrichtung,
- Fig. 2: eine Ausführungsform eines Elektronenstrahlobjektivs und deren Lage in Bezug auf die zu untersuchende Probe,
- Fig. 3: eine weitere Ausführungsform eines Elektronenstrahlobjektivs und deren Lage in Bezug auf die zu untersuchende Probe,
- Fig. 4: eine dritte Ausführungsform eines Elektronenstrahlobjektivs und deren Lage in Bezug auf die zu untersuchende Probe, und
- Fig. 5: eine vergrößerte Darstellung des in Fig. 4 mit einem gestrichelten Kreis gekennzeichneten Bereichs.

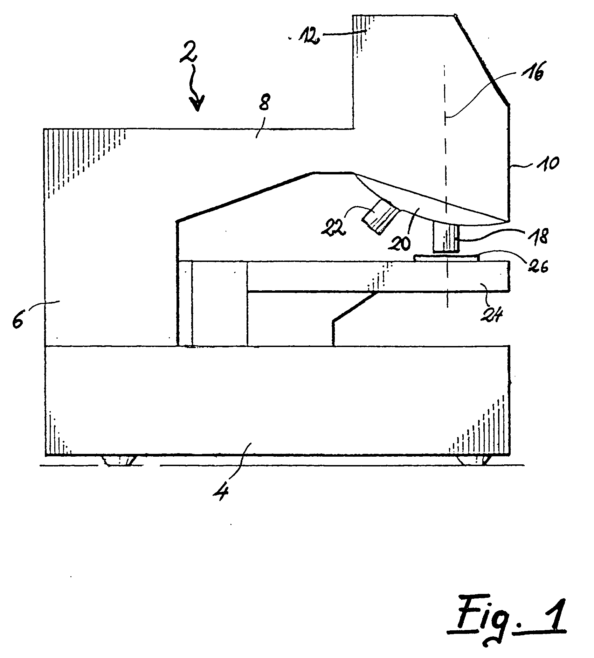

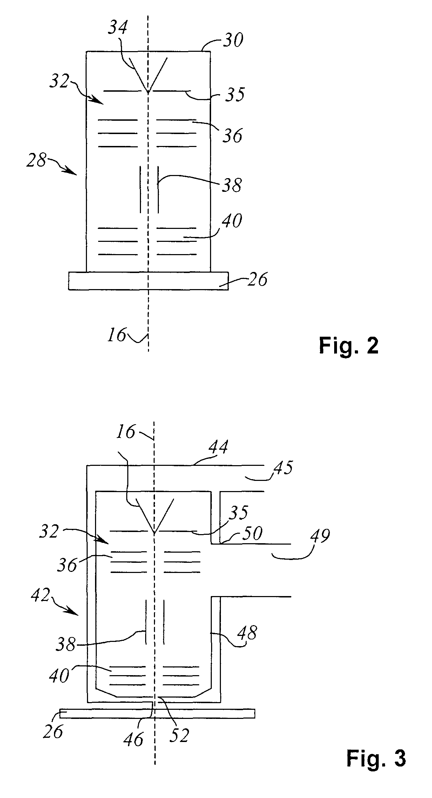

Fig. 1 zeigt den schematischen Aufbau der erfindungsgemäßen Vorrichtung 2. Das Mikroskop 2 ist im wesentlichen dem Aufbau eines herkömmlichen Mikroskops ähnlich. Das Mikroskop 2 besteht aus einem Fußelement 4, auf dem eine Säule 6 aufsitzt. An der Säule 6 ist ein Arm 8 befestigt oder angeformt. Der Arm 8 weist ein der Säule 6 abgewandtes Ende 10 auf. In der Nähe des vorderen Endes 10 des Arms 8 befindet sich eine optische Einheit 12, die im wesentlichen optische Elemente (nicht dargestellt) umfasst, die eine optische Achse 16 (in Fig. 1 gestrichelt dargestellt) festlegen. In der optischen Achse 16 ist ein Objektiv 18 vorgesehen, das die für das Mikroskop 2 gewünschte Vergrößerung festlegt. Um leichter zwischen verschiedenen Vergrößerungen wählen zu können, ist ein Revolver 20 vorgesehen, der zusätzlich zum bereits vorhandenen Objektiv 18 mindestens ein weiteres Objektiv 22 trägt. Auf den Aufbau und die einzelnen Bauteile eines herkömmlichen Mikroskops braucht hier nicht näher eingegangen zu werden, da dieses einem Fachmann hinreichend bekannt ist. Eins oder mehrere der am Revolver 20 befestigten Objektive 18 oder 22 sind als sogenannte Mikroobjektive für die Rasterelektronenmikroskopie (im Folgenden als Elektronenstrahlobjektive bezeichnet) ausgebildet. Die Größe der Elektronenstrahlobjektive ist mit der Größe der Objektive herkömmlicher Mikroskope vergleichbar. Die Elektronenstrahlobjektive sind als elektronenmikroskopische Säulen ausgebildet, die mit dem Aufbau herkömmlicher, makroskopischer Säulen der Rasterelektronenmikroskopie vergleichbar sind. Durch die Anordnung der Objektive 18 und 22 auf einen Revolver 20, einem Schieber oder einem anderen mechanischen und/oder elektromechanischen Bauteil kann schnell und einfach zwischen den verschiedenen Vergrößerungen gewechselt oder von herkömmlicher optischer Abbildung auf elektronenmikroskopische Abbildung umgeschaltet werden. Verschiedene Ausführungsformen des Objektivaufbaus werden genauer in Fig. 2 und Fig. 3 beschrieben. Auf dem Fuß 4 des Mikroskops ist ebenso ein Tisch 24 vorgesehen, mit dem eine zu untersuchende Probe 26 in die richtige Lage zum Objektiv 18 oder 22 gebracht werden kann.

Eine weitere Ausführungsform der gegenwärtigen Erfindung ist es, dass das Mikroskop 2 ausschließlich als Elektronenmikroskop verwendet wird. Dazu sind alle Objektive als elektronenmikroskopische Säulen ausgebildet Die Elektronenstrahlobjektive sind individuell mit einer Vakuumeinrichtung verbunden (nicht dargestellt), die für die Elektronenstrahlausbreitung im Elektronenstrahlobjektiv das geeignete Vakuum erzeugt.

Fig. 2 zeigt eine erste Ausführungsform eines Elektronenstrahlobjektivs 28. Das Elektronenstrahlobjektiv 28 besteht aus einem Gehäuse 30, in dem eine elektronenmikroskopische Säule 32 in mikroskopischer Form vorgesehen ist. Das Vakuumsystem (nicht dargestellt) für das Elektronenstrahlobjektiv 28 ist z.B. im Revolver 20 des Mikroskops 2 integriert. Der Aufbau der elektronenmikroskopischen Säule 32 ist symmetrisch um die durch die optische Einheit 12 des Mikroskops 2 definierte optische Achse 16. Ein Elektronenemitter 34 mit einer Blende 35 ist im oberen Bereich des Gehäuses 30 vorgesehen. Eine erste elektronenoptische Linse 36 ist nach der Blende 35 angebracht. Nach der elektronenoptischen Linse 36 ist ein Ablenkelement 38 angeordnet, auf das eine elektronenoptische Objektivlinse 40 folgt. Das Gehäuse 30 des Elektronenstrahlobjektivs 28 bildet mit der zu untersuchenden Probe 26 eine luftdichte Einheit. Dies kann dadurch erreicht werden, dass das Elektronenstrahlobjektiv 28 direkt auf der Probe 26 aufsitzt und somit den zu untersuchenden Bereich von der Umgebungsluft abschließt. Eine andere Möglichkeit ist, dass die Probe 26 in das Elektronenstrahlobjektivs 28 eingebracht wird und somit von der Umgebungsluft abgeschlossen ist. Es ist selbstverständlich, das die Elektronenstrahlobjektive 28 mit einer Steuerelektronik (nicht dargestellt) verbunden sind, um den Elektronenstrahl abzulenken oder zu formen. Die Steuerelektronik ist mit der Steuerelektronik herkömmlicher elektronenmikroskopischer Säulen vergleichbar und dem Fachmann hinlänglich bekannt, so dass in diesem Zusammenhang nicht näher darauf eingegangen werden muss.

Bei herkömmlichen Mikroskopen erfolgt der Objektivwechsel in der Umgebungsluft. Eine zweite Ausführungsform (Fig. 3) zeigt ein Elektronenstrahlobjektiv 42, das bei der Untersuchung von Proben bei normalen Umgebungsbedingungen (annähernd Umgebungsluftdruck) Verwendung findet. Das Elektronenstrahlobjektiv 42 besteht aus einem ersten Gehäuse 44, das eine Verbindung 45 zu einer ersten Vakuumeinrichtung (nicht dargestellt) aufweist. Ferner besitzt das erste Gehäuse 44 eine Austrittsöffnung 46 für den Elektronenstrahl. Die Austrittsöffnung 46 ist ebenfalls symmetrisch um die optische Achse 16 angeordnet. Ein zweites Gehäuse 48 umschließt die elektronenmikroskopische Säule 32. Das zweite Gehäuse 48 ist von dem ersten Gehäuse 44 umschlossen. Das zweite Gehäuse 48 hat eine zweite Verbindung 49 zu einer weiteren Vakuumeinrichtung (nicht dargestellt) ausgebildet. Dazu ist im ersten Gehäuse eine entsprechende Öffnung 50 ausgeformt, um eine Durchführung für die zweite Verbindung 49 zu erhalten. Die weitere Vakuumeinrichtung ist z.B. als eine Hochvakuumanlage ausgebildet. Durch die Vakuumanlagen wird im zweiten Gehäuse 48 ein Druck erzeugt, der geringer ist als der Druck, der durch die Vakuumeinrichtung im ersten Gehäuse 44 erzeugt wird. Es liegt also ein Druckunterschied beim Übergang vom zweiten zum ersten Gehäuse und beim Übergang vom ersten Gehäuse zur Umgebungsluft vor.

Ferner besitzt das zweite Gehäuse 48 ebenfalls eine Austrittsöffnung 52 für den Elektronenstrahl, die mit der Austrittsöffnung 46 im ersten Gehäuse 44 fluchtet. Wie bereits in Fig. 2 erläutert, ist im zweiten Gehäuse 48 die elektronenmikroskopische Säule 32 vorgesehen. Der Aufbau der elektronenmikroskopische Säule 32 ist symmetrisch um die durch die optische Einheit 12 des Mikroskops 2 definierte optische Achse 16. Ein Elektronenemitter 34 mit einer Blende 35 ist im oberen Teil des zweiten Gehäuses 48 vorgesehen. Eine erste elektronenoptische Linse 36 ist nach der Blende 35 vorgesehen. Nach der elektronenoptischen Linse 36 ist ein Ablenkelement 38 angeordnet, auf das eine elektronenoptische Objektivlinse 40 folgt. Das Elektronenstrahlobjektiv 42 ist bezüglich der zu untersuchenden Probe 26 derart angeordnet, dass zwischen der Probe 26 und der Öffnung 46 des ersten Gehäuses 44 Umgebungsluftdruck vorherrscht. Der Abstand zwischen der Probe 26 und der Öffnung 46 sollte sehr klein sein. Abstände im Bereich von 0,1 mm erweisen sich als sinnvoll.

Ferner kann das Elektronenstrahlobjektiv 42 aus mehr als zwei Gehäusen aufgebaut sein. Wie bereits oben erwähnt, wird dann in jedem der vorhandenen Gehäuse ein anderer Druck derart erzeugt, dass beim Übergang von Gehäuse zu Gehäuse bzw. zur Umgebungsluft ein Druckgradient vorliegt. Es ist immer so, dass das innerste Gehäuse den kleinsten Druck aufweist und der Druck zu den weiter außen liegenden Gehäusen in Stufen größer wird.

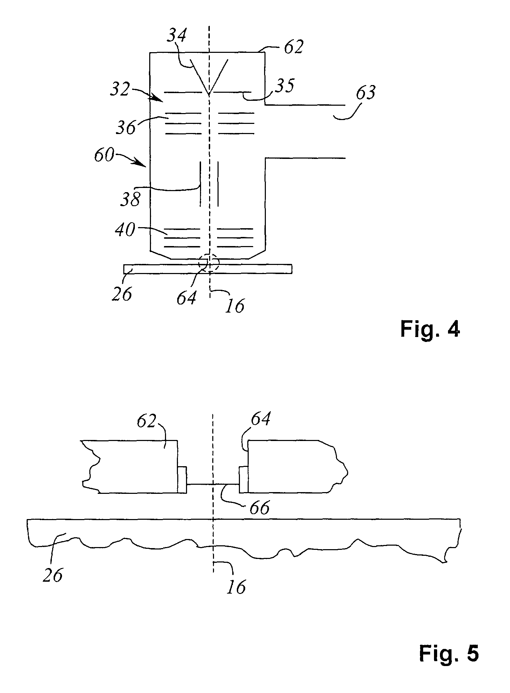

Eine dritte Ausführungsform eines Elektronenstrahlobjektivs 60 ist in Fig. 4 beschrieben. Das Elektronenstrahlobjektiv 60 besteht aus einem Gehäuse 62, das eine Verbindung 63 zu einer Vakuumeinrichtung (nicht dargestellt) offenbart. Im Inneren des Gehäuses 62 ist eine elektronenmikroskopische Säule 32 ausgebildet. Der Aufbau der elektronenmikroskopischen Säule 32 ist symmetrisch um die durch die optische Einheit 12 des Mikroskops 2 definierte optische Achse 16. Ein Elektronenemitter 34 mit einer Blende 35 ist im oberen Bereich des Gehäuses 60 vorgesehen. Eine erste elektronenoptische Linse 36 ist nach der Blende 35 vorgesehen. Nach der elektronenoptischen Linse 36 ist ein Ablenkelement 38 angeordnet, auf das eine elektronenoptische Objektivlinse 40 folgt. Das Elektronenstrahlobjektiv 60 definiert ebenfalls eine Öffnung 64, die symmetrisch um die optische Achse 16 angeordnet ist. Die Öffnung 64 ist mit einer Membran 66 (siehe Fig. 5) luftdicht abgeschlossen. Die Membran 66 ist derart ausgestaltet, dass sie für den Elektronenstrahl transparent ist. Das Elektronenstrahlobjektiv 60 ist bezüglich der zu untersuchenden Probe 26 derart angeordnet, dass zwischen der Probe 26 und der Membran 66 in der Öffnung 64 des Gehäuses 62 Umgebungsluftdruck vorherrscht. Der Abstand zwischen der Probe 26 und dem Elektronenstrahlobjektiv 60 liegt vorzugsweise im Bereich von 0,1 mm und kleiner.

Die in Fig. 2, Fig. 3 und Fig. 4 beschriebenen Ausführungsformen der Elektronenstrahlobjektive 28, 42 und 60 besitzen ein Länge von ca. 2 cm. Für die Fertigung der Elektronenstrahlobjektive 28, 42 und 60 wird die Mikrostrukturtechnik herangezogen. Die entsprechenden Strukturen werden z.B. aus Silizium gefertigt.

Die Erfindung wurde in Bezug auf besondere Ausführungsformen beschrieben. Es ist jedoch selbstverständlich, dass ein Fachmann Änderungen und Abwandlungen durchführen kann, ohne dabei den Schutzbereich der nachstehenden Ansprüche zu verlassen.

### Bezugszeichenliste

- 2: Vorrichtung
- 4: Fußelement
- 6: Säule
- 8: Arm
- 10: der Säule abgewandtes Ende
- 12: optische Einheit
- 16: optische Achse
- 18: Objektiv
- 20: Revolver
- 22: weiteres Objektiv
- 24: Tisch
- 26: Probe
- 28: Elektronenstrahlobjektiv
- 30: Gehäuse
- 32: elektronenmikroskopische Säule
- 34: Elektronenemitter
- 35: Blende
- 36: elektronenoptische Linse
- 38: Ablenkelement
- 40: elektronenoptische Objektivlinse
- 42: Elektronenstrahlobjektiv
- 44: erstes Gehäuse
- 45: erste Verbindung
- 46: Austrittsöffnung
- 48: zweites Gehäuse
- 49: zweite Verbindung
- 50: Öffnung
- 52: Austrittsöffnung
- 60: Elektronenstrahlobjektiv
- 62: Gehäuse
- 63: Verbindung
- 64: Öffnung
- 66: Membran

## Patentansprüche

1. Mikroskop (2), in dem eine optische Einheit (12) eine optische Achse definiert, **dadurch gekennzeichnet,** dass mindestens ein in der optischen Achse (16) anordenbares Objektiv (22) als ein Elektronenstrahlobjektiv (28, 42) ausgebildet ist.

2. Mikroskop (2) nach Anspruch 1, **dadurch gekennzeichnet,** dass mehrere Objektive (18, 22) auf einem Revolver (20) angeordnet sind, wobei mindestes ein Objektiv (22) als ein Elektronenstrahlobjektiv (28, 42) ausgebildet ist.

3. Mikroskop (2) nach Anspruch 1, **dadurch gekennzeichnet,** dass das Elektronenstrahlobjektiv (28, 42) aus einer elektronenmikroskopischen Säule (32) besteht, die in einem Gehäuse (30) symmetrisch um die optische Achse (16) angeordnet ist.

4. Mikroskop (2) nach Anspruch 3, **dadurch gekennzeichnet,** dass das Elektronenstrahlobjektiv (28) mit einer zu untersuchenden Probe (26) eine luftdichte Einheit bildet.

5. Mikroskop (2) nach Anspruch 1 **dadurch gekennzeichnet,** dass das Elektronenstrahlobjektiv (42) von der Oberfläche einer zu untersuchenden Probe (26) etwas beabstandet ist und dass zwischen dem Elektronenstrahlobjektiv (42) und der Probe (26) annähernd Umgebungsluftdruck vorherrscht.

6. Mikroskop (2) nach Anspruch 5, **dadurch gekennzeichnet,** dass das Elektronenstrahlobjektiv (42) aus einem ersten Gehäuse (44) besteht, das ein zweites Gehäuse (48) umschließt, wobei eine elektronenmikroskopische Säule (32) im zweiten Gehäuse (48) symmetrisch um die optische Achse (16) angeordnet ist, und im ersten Gehäuse (44) ein geringerer Luftdruck herrscht als im zweiten Gehäuse (48).

7. Mikroskop (2) nach Anspruch 6, **dadurch gekennzeichnet,** dass das erste Gehäuse (44) eine Verbindung (45) zu einer Vakuumeinrichtung und das zweite Gehäuse (48) eine Verbindung (49) zu einer anderen Vakuumeinheit aufweist.

8. Mikroskop (2) nach Anspruch 6, **dadurch gekennzeichnet,** dass das erste Gehäuse (44) eine Öffnung (46) und das zweite Gehäuse eine Öffnung (52) für den Elektronenstrahl aufweist, die beide symmetrisch um die optische Achse (16) angeordnet sind.

9. Mikroskop (2) nach Anspruch 5, **dadurch gekennzeichnet,** dass das Elektronenstrahlobjektiv aus einem einzelnen Gehäuse (62) besteht und eine Öffnung (64) für den Elektronenstrahl aufweist, und wobei die Öffnung (64) mit einer für Elektronenstrahlen transparenten Membran (66) luftdicht verschlossen ist.

10. Mikroskop (2) nach einem der vorangehenden Ansprüche, **dadurch gekennzeichnet,** dass die Elektronenstrahlobjektive (28, 42, 60) eine Länge besitzen, die mit der Länge herkömmlicher Objektive für Lichtmikroskope vergleichbar ist.
